# EUROPÄISCHE PATENTSCHRIFT

(11) **EP 0 761 721 B1**
(45) Veröffentlichungstag und Bekanntmachung des Hinweises auf die Patenterteilung: **28.02.2001**
(21) Anmeldenummer: 96113308.9
(22) Anmeldetag: 19.08.1996
(51) Int. Cl.: C08G 73/22, C08G 75/32, C08G 69/32, G03F 7/038

(54) **Verfahren zur Herstellung von Poly-o-hydroxyamiden und Poly-o-mercaptoamiden**
Process for the preparation of poly-o-hydroxyamides and poly-o-mercaptoamides
Procédé pour la préparation de poly-o-hydroxyamides et de poly-o-mercaptoamides

(30) Priorität: 31.08.1995 DE 19532200
(43) Veröffentlichungstag der Anmeldung: 12.03.1997
(73) Patentinhaber: Infineon Technologies AG, 81541 München (DE)
(72) Erfinder: Sezi, Recai, Dr., 91341 Röttenbach (DE); Ahne, Hellmut, Dr., 91341 Röttenbach (DE); Kühn, Eberhard, 91334 Hemhofen (DE)
(74) Vertreter: Zedlitz, Peter, Dipl.-Inf.

(56) Entgegenhaltungen:
- FR-A- 2 595 362

## Beschreibung

Die Erfindung betrifft ein Verfahren zur Herstellung von Poly-o-hydroxyamiden (Polybenzoxazol-Vorstufen) und Poly-o-mercaptoamiden (Polybenzothiazol-Vorstufen).

In der Mikroelektronik werden hochwärmebeständige Polymere benötigt, insbesondere als Schutz- und Isolierschichten bzw. als Dielektrika (siehe dazu beispielsweise: "SAMPE Journal", Vol. 25 (1989), No. 6, Seiten 18 bis 23, und "Proceedings of the 1992 International Conference on Multichip Modules", Seiten 394 bis 400). Einige der verwendeten Polymere, beispielsweise Homo- und Copolymere aromatischer Polyether sowie Vorstufen von Polyimiden (PI) und Polybenzoxazolen (PBO), weisen eine gute Löslichkeit in organischen Lösungsmitteln und gute Filmbildungseigenschaften auf und können mittels Schleudertechnik auf elektronische Bauteile aufgebracht werden (siehe dazu beispielsweise: "High Performance Polymers", Vol. 4 (1992), No. 2, Seiten 73 bis 80, und "Polymers for Advanced Technologies", Vol. 4 (1993), Seiten 217 bis 233).

Polymer-Vorstufen der genannten Art werden durch eine Temperaturbehandlung cyclisiert, d.h. in die entsprechenden Polymere (PI bzw. PBO) umgewandelt; dabei ergeben sich die endgültigen Eigenschaften. Durch die Cyclisierung verschwinden nämlich die hydrophilen Gruppierungen des Poly-o-hydroxyamids, d.h. die NH-, OH- und CO-Gruppen, welche die dielektrischen Eigenschaften und die Wasseraufnahme negativ beeinflussen würden. Dies ist beispielsweise ein wesentlicher Vorteil der Polybenzoxazole gegenüber den Polyimiden (mit zwei CO-Gruppen pro Imideinheit) und insbesondere gegenüber den Hydroxypolyimiden (mit zwei CO-Gruppen und einer OH-Gruppe pro Imideinheit). Außerdem ist die Cyclisierung nicht nur für die guten dielektrischen Eigenschaften und die geringe Wasseraufnahme des Endproduktes wichtig, sondern auch für dessen hohe Temperaturstabilität.

PI- und PBO-Vorstufen können, beispielsweise durch Zusatz geeigneter photoaktiver Komponenten, photosensitiv eingestellt und dann direkt strukturiert werden, d.h. ohne die Verwendung eines Hilfsresists. Dies ist deswegen bedeutsam, weil die direkte Strukturierung - im Vergleich mit der indirekten Strukturierung - erhebliche Kostenvorteile bietet.

Photosensitive PBO-Vorstufen bieten, im Gegensatz zu den meisten photosensitiven PI-Vorstufen, die Vorteile der positiven Strukturierbarkeit, wie geringere Defektdichte bei der Strukturierung der sogenannten "via holes", weil - im Vergleich mit negativ arbeitenden Systemen - nur ein Bruchteil der Fläche belichtet wird. Beim Einsatz alkalilöslicher PBO-Vorstufen ergibt sich außerdem die Möglichkeit einer wäßrig-alkalischen Entwicklung. Nach der Photostrukturierung erfolgt dann die Cyclisierung der Vorstufen durch Temperung.

Wäßrig-alkalisch entwickelbare PBO-Vorstufen sind bereits bekannt (siehe dazu: EP-PS 0 023 662, EP-OS 0 264 678 und EP-PS 0 291 779). Der dabei angewendete photolithographische Prozeß ist, bis auf die Cyclisierung, der gleiche wie bei der Strukturierung bekannter Positivresists auf der Basis von Novolaken und Chinonaziden, eines weltweit in zahlreichen Fertigungslinien eingesetzten Prozesses (siehe dazu beispielsweise: D.S. Soane und Z. Martynenko "Polymers in Microelectronics - Fundamentals and Applications", Elsevier, Amsterdam 1989, Seiten 77 bis 124).

Die Alkalilöslichkeit der PBO-Vorstufen ist eine wichtige Voraussetzung für deren Einsatz als Basispolymer für wäßrig-alkalisch entwickelbare photosensitive Dielektrika. Für mikroelektronische Anwendungen müssen die Vorstufen in metallionenfreien Entwicklern löslich sein, damit derartige Entwickler auch bei der Photostrukturierung verwendet werden können. Entwickler, welche Metallionen enthalten, können nämlich die elektrische Funktion der Bauteile negativ beeinflussen.

Die gängigste Methode zur Herstellung von alkalilöslichen PBO-Vorstufen, d.h. von Poly-o-hydroxyamiden, ist die Umsetzung eines Dicarbonsäurechlorids mit einem geeigneten Bis-o-aminophenol. Zum Abfangen des bei der Reaktion entstehenden Chlorwasserstoffs wird in der Regel eine lösliche Base, wie Pyridin, zugesetzt (siehe: EP-OS 0 264 678 und EP-PS 0 291 779). Nach dieser Methode sind nun zwar Vorstufen herstellbar, welche in metallionenfreien wäßrig-alkalischen Entwicklern löslich sind, von Nachteil ist jedoch, daß Chloridionen im Polymer verbleiben. Ein derartiges Polymer ist aber als Beschichtungsmaterial für mikroelektronische Bauteile nicht brauchbar, weil die Chloridionen Korrosion verursachen und die Funktion der Bauteile somit stark beeinträchtigen können. Es ist deshalb eine Reinigung des Polymers mittels Ionenaustauscher erforderlich. Diese Reinigung ist jedoch aufwendig und teuer, sie umfaßt nämlich zusätzliche Prozeßschritte, wie die Vorbereitung der Ionenaustauschersäule, das Lösen des Polymers, das Durchlaufen der Lösung durch die Säule und das Nachwaschen sowie die erneute Ausfällung und Trocknung.

Bei der Herstellung von Poly-o-hydroxyamiden muß auch die Forderung erfüllt werden, daß das Dicarbonsäurechlorid vorwiegend mit den Aminogruppen des Bis-o-aminophenols reagiert (unter Amidbildung), nicht aber mit dessen Hydroxylgruppen (unter Esterbildung), d.h. die Reaktionsselektivität der Amidbildung gegenüber der Esterbildung muß hoch sein. Kann die Esterbildung nicht ausgeschlossen bzw. stark unterdrückt werden, dann führt dies zu unzureichend alkalilöslichen Polymeren. Eine geringe Reaktionsselektivität kann ferner zu einer Gelbildung in der Polymerlösung führen, wobei das hergestellte Poly-o-hydroxyamid dann unfiltrierbar und somit unbrauchbar ist.

Es wurden auch bereits Verfahren zur chloridfreien Synthese von Poly-o-hydroxyamiden - und ebenso von Poly-o-mercaptoamiden - beschrieben. So ist es aus der EP-OS 0 158 726 bekannt, Dihydroxy- bzw. Dimercaptodiaminoverbindungen in Gegenwart eines Carbodiimids mit einer Dicarbonsäure umzusetzen. Bei dieser Reaktion bereiten jedoch Harnstoffreste, die aufgrund einer Umlagerungsreaktion am Harz verbleiben, oft Probleme. Sie beeinträchtigen nämlich die thermische Beständigkeit des Polybenzoxazols bzw. Polybenzothiazols sowie die Qualität der daraus hergestellten Schichten. Außerdem sind die nach diesem Verfahren hergestellten Polymere in metallionenfreien wäßrig-alkalischen Entwicklern nicht ausreichend löslich.

Ein alternatives chloridfreies Herstellungsverfahren für Poly-o-hydroxyamide besteht darin, zur Umsetzung der Dicarbonsäure mit dem Bis-o-aminophenol Kondensationsreagenzien wie 1-Ethoxycarbonyl-2-ethoxy-1,2-dihydrochinolin und 1,1'-Carbonyldioxy-di-1,2,3-benzotriazol einzusetzen (siehe: EP-OS 0 391 196). Die auf diese Weise hergestellten Polymere zeigen aber in metallionenfreien wäßrig-alkalischen Entwicklern ebenfalls nur eine unzureichende Löslichkeit.

Es sind auch Verfahren bekannt, bei denen die Amidbildung mittels Phosphorverbindungen erfolgt (siehe dazu: EP-OS 0 481 402, US-PS 4 331 592 und DE-OS 37 16 629). Bei Poly-o-hydroxyamiden führen derartige Synthesen aber entweder zu cyclisierten, d.h. alkaliunlöslichen Produkten oder es verbleiben im Polymer phosphorhaltige, teilweise auch chemisch gebundene Reste, wodurch das Polymer, wegen der Dotierungseigenschaften von Phosphor, für mikroelektronische Anwendungen unbrauchbar wird. Im Gegensatz zu ionischen Verunreinigungen können nämlich derartige Reste beispielsweise nicht mittels Ionenaustauscher entfernt werden.

Aufgabe der Erfindung ist es, ein kostengünstiges Verfahren anzugeben, mit dem - auf chloridfreiem Weg - Poly-o-hydroxyamide und Poly-o-mercaptoamide hergestellt werden können, welche in metallionenfreien wäßrig-alkalischen Entwicklern löslich sind.

Dies wird erfindungsgemäß dadurch erreicht, daß ein Bis-o-aminophenol bzw. ein Bis-o-aminothiophenol mit einem Dicarbonsäurederivat folgender Struktur umgesetzt wird: 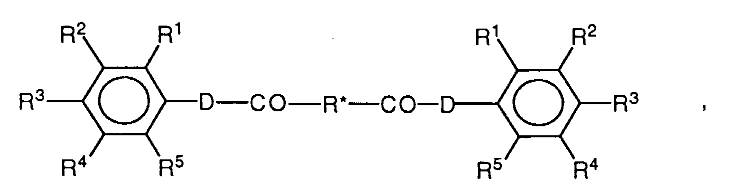 wobei folgendes gilt:
D = O, S oder NH;
R¹, R², R³, R⁴ und R⁵ sind - unabhängig voneinander - H, F, CH₃ oder CF₃, wobei mindestens einer der Reste R¹ bis R⁵ F bzw. CF₃ ist und höchstens zwei der Reste R¹ bis R⁵ CH₃ bzw. CF₃ sind;
R* hat folgende Bedeutung:

- (CR₂)ₘ mit R = H, F, CH₃ oder CF₃
   und m = 1 bis 10;
- 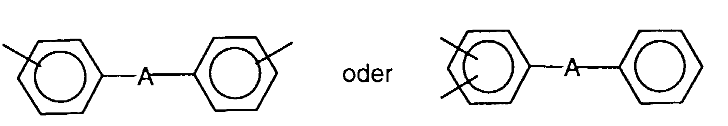 mit A =: (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF(CF₃), CH=CH, CF=CF, C≡C, O-C₆H₄-O, O, S, CO oder SO₂, wobei n = 0 bis 10 und p = 1 bis 10;
- 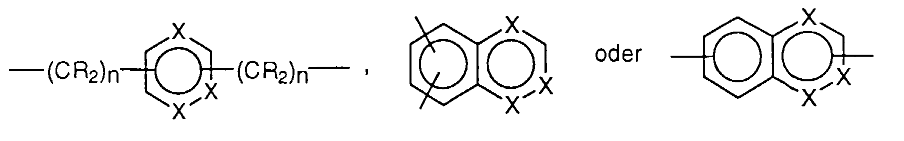 mit
   X = CH oder N
   R = H, F, CH₃ oder CF₃
   und
   n = 0 bis 10;
- 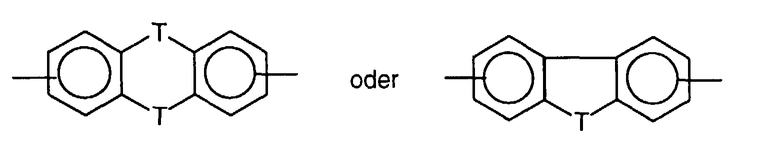 mit T = CH₂, CF₂, CO, O, S, NH oder N(CH₃);
- 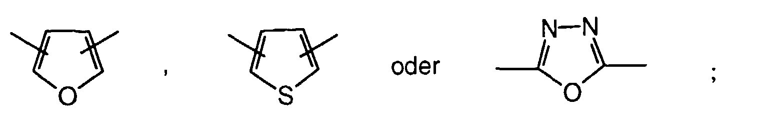
- 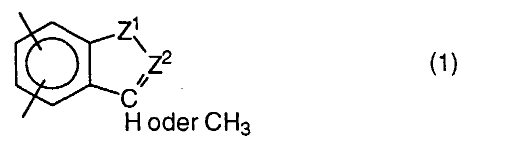 mit
   (a) Z¹ = CH₂ oder CH(CH₃) und Z² = CH oder C(CH₃)
   (b) Z¹ = CH₂ oder CH(CH₃) und Z² = N
   (c) Z¹ = NH oder N(CH₃) und Z² = CH oder C(CH₃)
   (d) Z¹ = NH oder N(CH₃) und Z² = N 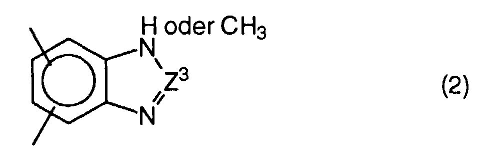
   mit
   (a) Z³ = CH oder C(CH₃)
   (b) Z³ = N 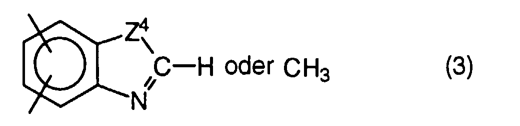
   mit
   (a) Z⁴ = O
   (b) Z⁴ = S;
wobei an allen aromatischen Partialstrukturen jeweils sämtliche Wasserstoffatome (H) durch Fluor (F) ersetzt sein können.

Die Erfindung löst das vorstehend geschilderte Problem in der Weise, daß als Dicarbonsäurekomponente spezielle Dicarbonsäurederivate eingesetzt werden, und zwar fluorhaltige Ester mit Phenolen bzw. entsprechende Thioester und Amide. Überraschenderweise ergibt sich hierbei eine ausreichende Selektivität der Amidbildung. Die erfindungsgemäß hergestellten Polymere, d.h. die Poly-o-hydroxy- und Poly-o-mercaptoamide, sind nämlich in metallionenfreien wäßrig-alkalischen Entwicklern löslich. Außerdem läuft das Verfahren nach der Erfindung ohne Gelbildung ab, so daß die genannten Polymere in organischen Lösungsmitteln gut löslich und verarbeitbar sind. Ferner werden bei diesem Verfahren Verunreinigungen wie Chlorid- und Metallionen sowie Phosphorverbindungen vermieden.

Zur Synthese der Polymere dienen spezielle Verbindungen aus Dicarbonsäuren und F- und/oder CF₃-Gruppen enthaltenden Phenolen, Thiophenolen und Aminobenzolen (Anilinen), insbesondere einem Fluorphenol, vorzugsweise perfluoriertem Phenol, d.h. Pentafluorphenol. Es können aber auch Derivate mit CH₃-Substituenten eingesetzt werden. Eine Reihe derartiger Verbindungen (Ester, Thioester und Amide) ist Gegenstand der gleichzeitig eingereichten deutschen Patentanmeldung Akt.Z. 195 32 138.3 - "Neue Dicarbonsäurederivate" (GR 95 P 3618).

Zur Synthese der Vorstufen werden vorzugsweise Derivate von Dicarbonsäuren wie 1,3-Benzoldicarbonsäure (Isophthalsäure) und Diphenylether-4,4'-dicarbonsäure (Oxydibenzoesäure) eingesetzt. Es kann jedoch allgemein auf solche Dicarbonsäuren zurückgegriffen werden, wie sie zur Herstellung von Vorstufen der genannten Art Verwendung finden.

Besonders geeignete Bis-o-aminophenole sind 2,2-Bis-(3-amino-4-hydroxyphenyl)-hexafluorpropan und 3,3'-Dihydroxy-4,4'-diaminodiphenyl. Zur Synthese von Poly-o-mercaptoamiden dienen die entsprechenden Bis-o-aminothiophenole. Prinzipiell können aber alle Bis-o-aminophenole und -thiophenole eingesetzt werden, die üblicherweise zur Herstellung von Polybenzoxazol- bzw. Polybenzothiazol-Vorstufen Verwendung finden.

Die Umsetzung des Dicarbonsäurederivates mit dem Bis(thio)phenol erfolgt vorteilhaft in Gegenwart eines basischen Katalysators, der vorzugsweise ein tertiäres Amin ist. Derartige Katalysatoren sind insbesondere Pyridin, Triethylamin, Diazabicyclooctan und Polyvinylpyridin. Es können aber auch andere basische Katalysatoren verwendet werden, wobei solche bevorzugt sind, welche in dem bei der Synthese der Vorstufe verwendeten Lösungsmittel, wie N-Methylpyrrolidon, oder in Wasser bzw. Wasser/Alkohol-Mischungen (Fällungsmittel) gut löslich sind, oder solche, welche vollkommen unlöslich sind, wie vernetztes Polyvinylpyridin.

Die Reaktionstemperatur bei der Umsetzung zwischen dem Dicarbonsäurederivat und dem (Thio)phenol beträgt vorzugsweise zwischen 20 und 150°C. Für die Reaktionsselektivität hat es sich dabei als vorteilhaft erwiesen, die Temperatur stufenweise zu erhöhen.

Das Verfahren nach der Erfindung wird deshalb vorteilhaft in der Weise durchgeführt, daß das Dicarbonsäurederivat, das Bis-o-aminophenol bzw. -thiophenol und ein basischer Katalysator bei Raumtemperatur, gegebenenfalls bei erhöhter Temperatur, in einem organischen Lösungsmittel gelöst werden, und daß dann stufenweise erwärmt wird. Nach Beendigung der Reaktion läßt man die Reaktionslösung auf Raumtemperatur abkühlen, dann wird das Reaktionsprodukt mit einem geeigneten Fällungsmittel ausgefällt. Nach Filtration und Trocknung ist das ausgefällte Polymer einsatzfähig. Beim Verfahren nach der Erfindung erübrigen sich somit umständliche Reinigungsschritte, wie die Reinigung des Polymers mittels Ionenaustauscher.

Geeignete Lösungsmittel sind im übrigen N-Methylpyrrolidon, Tetrahydrofuran und N,N-Dimethylacetamid. Prinzipiell kann jedoch jedes Lösungsmittel verwendet werden, in dem die Ausgangskomponenten gut löslich sind. Als Fällungsmittel sind Wasser und Mischungen von Wasser mit Alkoholen wie Ethanol und Isopropanol besonders geeignet.

Beim Verfahren nach der Erfindung können - bei einem Überschuß an Bis-o-aminophenol oder -thiophenol - die Aminoendgruppen des hergestellten Poly-o-hydroxyamids bzw. -mercaptoamids vor dem Ausfällen des Polymers mit einem Dicarbonsäureanhydrid verkappt, d.h. blockiert werden. Hierzu eignet sich insbesondere cis-5-Norbornen-endo-2,3-dicarbonsäureanhydrid.

Anhand von Ausführungsbeispielen soll die Erfindung noch näher erläutert werden.

### Beispiel 1

### Herstellung einer PBO-Vorstufe

In einen 250 ml-Dreihalskolben werden unter Stickstoff (als Schutzgas) 8,0 g eines Diesters aus Isophthalsäure und Perfluorphenol, 6,51 g 2,2-Bis-(3-amino-4-hydroxyphenyl)-hexafluorpropan, 2,53 g Pyridin und 95 ml trockenes N-Methylpyrrolidon gegeben. Diese Mischung wird dann 16 h bei Raumtemperatur gerührt und anschließend 24 h bei 90°C sowie 50 h bei 120°C. Nach dem Abkühlen auf Raumtemperatur werden - zur Blockierung der Endgruppen - 0,27 g cis-5-Norbornen-endo-2,3-dicarbonsäureanhydrid, gelöst in 2 ml N-Methylpyrrolidon, zugegeben, und dann wird die Reaktionslösung weitere 14 h bei Raumtemperatur gerührt. Die hellbraune Reaktionslösung wird danach unter starkem Rühren in die 10fache Menge einer Mischung aus vier Volumenteilen Wasser und einem Volumenteil Isopropanol (als Fällungsmittel) getropft. Das ausgefallene Polymer wird abfiltriert, viermal mit je 200 ml Fällungsmittel gewaschen und mit 1000 ml Fällungsmittel versetzt, und dann wird 16 h gerührt. Nachfolgend wird das Polymer abfiltriert und danach zunächst 24 h bei ca. 20 mbar und dann acht Tage bei ca. 2 mbar, jeweils bei 50°C, getrocknet. Die Ausbeute beträgt 7,0 g.

### Beispiel 2

### Löslichkeit der PBO-Vorstufe

1 g der nach Beispiel 1 hergestellten PBO-Vorstufe wird in 3 g Diethylenglykoldiethylether gelöst und die Lösung in eine Plastikspritze gegeben, die mit einem Vorfilter versehen ist. Die Polymerlösung wird dann mittels der Spritze auf einen gereinigten und getrockneten Siliciumwafer aufgetragen und dieser in einer Schleuderapparatur (Fa. Convac, Typ ST 146) geschleudert. Der auf dem Wafer gebildete Film wird bei 120°C auf einer Heizplatte getrocknet. Nach dem Abkühlen wird der mit dem Polymerfilm beschichtete Wafer in einen kommerziell erhältlichen metallionenfreien wäßrig-alkalischen Entwickler (NSD-TD, Fa. Tokyo Ohka) getaucht. Hierbei löst sich der Polymerfilm gleichmäßig auf, d.h. ohne Rißbildungen und ohne abzuplatzen. Bereits nach kurzer Zeit ist der ganze Polymerfilm vollständig im Entwickler gelöst. Das gleiche Ergebnis wird erhalten, wenn anstelle des vorstehend genannten Entwicklers eine 3 %ige Lösung von Tetramethylammoniumhydroxid in destilliertem Wasser verwendet wird.

### Beispiel 3

### Photostrukturierung der PBO-Vorstufe

0,8 g der nach Beispiel 1 hergestellten PBO-Vorstufe und 0,2 g eines Diesters aus Naphthochinondiazid-4-sulfonsäure und Bisphenol-A (als photoaktive Komponente) werden in 3 g Diethylenglykoldiethylether gelöst. Die dabei erhaltene Resistlösung wird dann entsprechend Beispiel 2 auf einen Siliciumwafer aufgebracht und getrocknet. Anschließend wird eine Hälfte des Wafers mit einer Aluminiumfolie abgedeckt und die andere Hälfte mit einer Quecksilber/Xenon-Lampe bestrahlt. Der Wafer wird dann in eine kommerzielle Entwicklerlösung entsprechend Beispiel 2 eingetaucht. Dabei wird festgestellt, daß nur die belichteten Bereiche selektiv und gleichmäßig herausgelöst werden (Positivresist).

### Beispiel 4

### Herstellung einer PBO-Vorstufe

In einen 250 ml-Dreihalskolben werden unter Stickstoff (als Schutzgas) 6,0 g eines Diesters aus Diphenylether-4,4'-dicarbonsäure und Perfluorphenol, 4,1 g 2,2-Bis-(3-amino-4-hydroxyphenyl)-hexafluorpropan, 2,1 g Triethylamin und 65 ml trockenes N-Methylpyrrolidon gegeben. Diese Mischung wird dann 8 h bei Raumtemperatur gerührt und anschließend 20 h bei 80°C sowie 24 h bei 110°C. Nach dem Abkühlen auf Raumtemperatur werden - zur Blockierung der Endgruppen - 0,17 g cis-5-Norbornen-endo-2,3-dicarbonsäureanhydrid, gelöst in 1 ml N-Methylpyrrolidon, zugegeben, und dann wird die Reaktionslösung weitere 14 h bei Raumtemperatur gerührt. Die hellbraune Reaktionslösung wird danach unter starkem Rühren in die 10fache Menge einer Mischung aus vier Volumenteilen Wasser und einem Volumenteil Isopropanol (als Fällungsmittel) getropft. Das ausgefallene Polymer wird abfiltriert, viermal mit je 200 ml Fällungsmittel gewaschen und mit 1000 ml Fällungsmittel versetzt, und dann wird 16 h gerührt. Nachfolgend wird das Polymer abfiltriert und danach zunächst 24 h bei ca. 20 mbar und dann acht Tage bei ca. 2 mbar, jeweils bei 50°C, getrocknet. Die Ausbeute beträgt 4,2 g.

### Beispiel 5

### Löslichkeit der PBO-Vorstufe

Wird mit der nach Beispiel 4 hergestellten PBO-Vorstufe wie in Beispiel 2 verfahren, so wird das gleiche Ergebnis erhalten, d.h. die PBO-Vorstufe löst sich in beiden metallionenfreien wäßrig-alkalischen Entwicklern gleichmäßig auf.

### Beispiel 6

### Photostrukturierung der PBO-Vorstufe

Wird mit der nach Beispiel 4 hergestellten PBO-Vorstufe wie in Beispiel 3 verfahren, so wird das gleiche Ergebnis erhalten, d.h. es werden nur die belichteten Bereiche selektiv und gleichmäßig herausgelöst.

## Patentansprüche

1. Verfahren zur Herstellung von Poly-o-hydroxyamiden und Poly-o-mercaptoamiden, **dadurch gekennzeichnet,** daß ein Bis-o-aminophenol bzw. ein Bis-o-aminothiophenol mit einem Dicarbonsäurederivat folgender Struktur umgesetzt wird: 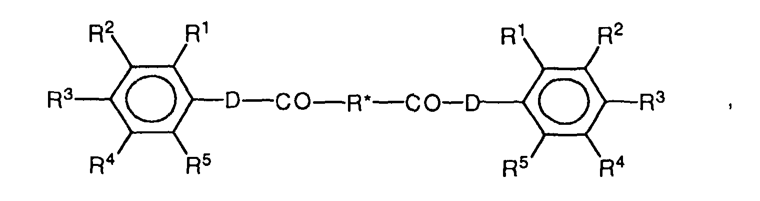 wobei folgendes gilt:
D = O, S oder NH;
R¹, R², R³, R⁴ und R⁵ sind - unabhängig voneinander - H, F, CH₃ oder CF₃, wobei mindestens einer der Reste R¹ bis R⁵ F bzw. CF₃ ist und höchstens zwei der Reste R¹ bis R⁵ CH₃ bzw. CF₃ sind;
R* hat folgende Bedeutung:
- (CR₂)ₘ mit R = H, F, CH₃ oder CF₃
und m = 1 bis 10;
- 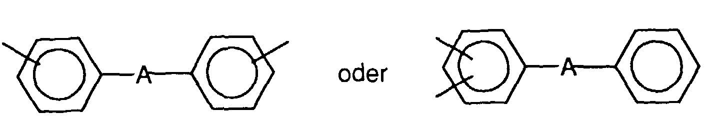
mit A = (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF(CF₃), CH=CH, CF=CF, C≡C, O-C₆H₄-O, O, S, CO oder SO₂, wobei n = 0 bis 10 und p = 1 bis 10;
- 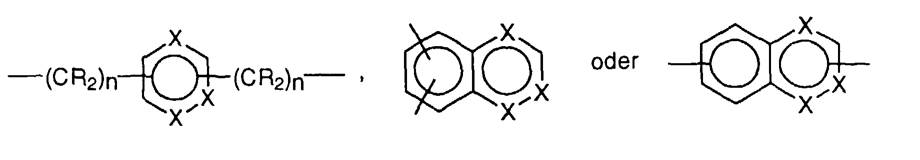 mit
X = CH oder N
R = H, F, CH₃ oder CF₃
und
n = 0 bis 10;
- 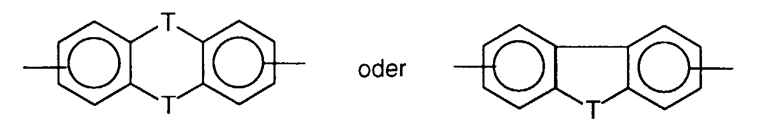 mit T = CH₂, CF₂, CO, O, S, NH oder N(CH₃);
- 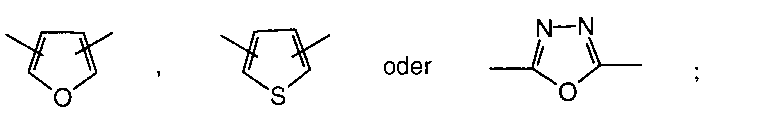
- 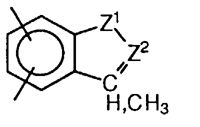 mit
Z¹ = CH₂ oder CH(CH₃) und Z² = CH oder C(CH₃)
Z¹ = CH₂ oder CH(CH₃) und Z² = N
Z¹ = NH oder N(CH₃) und Z² = CH oder C(CH₃)
Z¹ = NH oder N(CH₃) und Z² = N 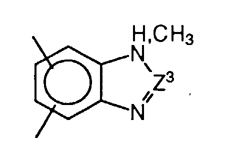
mit Z³ = CH, C(CH₃) oder N 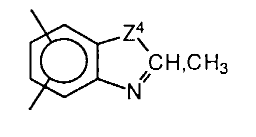 mit Z⁴ = O oder S; wobei an allen aromatischen Partialstrukturen jeweils sämtliche Wasserstoffatome (H) durch Fluor (F) ersetzt sein können.

2. Verfahren nach Anspruch 1, **dadurch gekennzeichnet**, daß ein Dicarbonsäureester mit Perfluorphenol eingesetzt wird.

3. Verfahren nach Anspruch 1 oder 2, **dadurch gekennzeichnet,** daß die Umsetzung in Gegenwart eines basischen Katalysators erfolgt.

4. Verfahren nach Anspruch 3, **dadurch gekennzeichnet**, daß der Katalysator ein tertiäres Amin ist.

5. Verfahren nach einem der Ansprüche 1 bis 4, **dadurch gekennzeichnet**, daß die Umsetzung bei Temperaturen von 20 bis 150°C durchgeführt wird.

6. Verfahren nach Anspruch 5, **dadurch gekennzeichnet**, daß die Temperatur stufenweise erhöht wird.

## Claims

1. Process for preparing poly-o-hydroxyamides and poly-o-mercaptoamides, characterized in that a bis-o-aminophenol or a bis-o-aminothiophenol is reacted with a dicarboxylic acid derivative having the following structure: 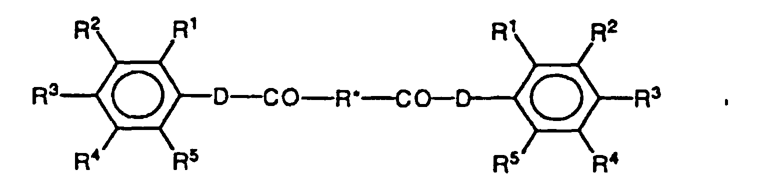 where:
D = O, S or NH;
R¹, R², R³, R⁴ and R⁵ are, independently of one another, H, F, CH₃ or CF₃, where at least one of the radicals R¹ to R⁵ is F or CF₃ and not more than two of the radicals R¹ to R⁵ are CH₃ or CF₃;
R* has the following meaning:
- (CR₂)ₘ where R = H, F, CH₃ or CF₃
and m = 1 to 10; 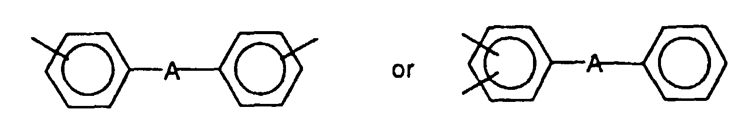
where A = (CH₂)ₙ, (CF₂)ₚ, C(CH₃)₂, C(CF₃)₂, C(CH₃)(C₆H₅), C(CF₃(C₆H₅), C(CF₃)(C₆F₅), C(C₆H₅)₂, CF₂-CF(CF₃), CH=CH, CF=CF, C≡C, O-C₆H₄-O, O, S, CO or SO₂, where n = 0 to 10 and p = 1 to 10; 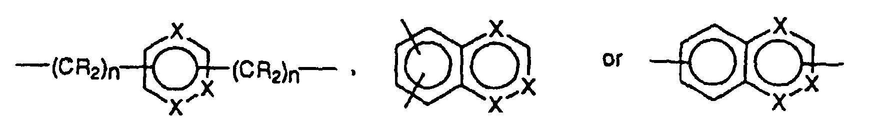
where
X = CH or N
R = H, F, CH₃ or CF₃
and
n = 0 to 10; 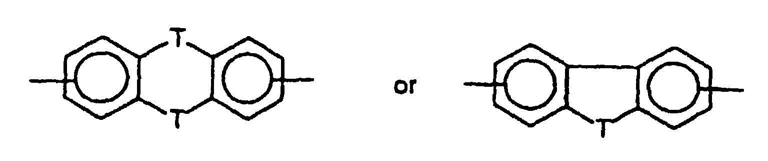 where T = CH₂, CF₂, CO, O, S, NH or N(CH₃);
- 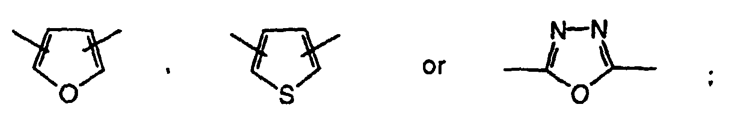
- 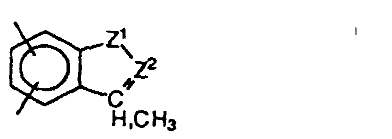 where
Z¹ = CH₂ or CH(CH₃) and Z² = CH or C(CH₃)
Z¹ = CH₂ or CH(CH₃) and Z² = N
Z¹ = NH or N(CH₃) and Z² = CH or C(CH₃)
Z¹ = NH or N(CH₃) and Z² = N 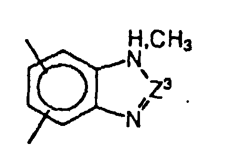
where Z³ = CH, C(CH₃) or N 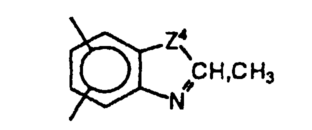 where Z⁴ = O or S;
where all hydrogen atoms (H) can in each case be replaced by fluorine (F) in all aromatic substructures.

2. Process according to Claim 1, characterized in that a dicarboxylic ester with perfluorophenol is used.

3. Process according to Claim 1 or 2, characterized in that the reaction is carried out in the presence of a basic catalyst.

4. Process according to Claim 3, characterized in that the catalyst is a tertiary amine.

5. Process according to any of Claims 1 to 4, characterized in that the reaction is carried out at temperatures of from 20 to 150°C.

6. Process according to Claim 5, characterized in that the temperature is increased in steps.

## Revendications

1. Procédé pour la préparation de poly-o-hydroxyamides et de poly-o-mercapto-amides **caractérisé par le fait** qu'un bis-o-aminophénole ou un bis-o-aminothiophénole est transformé avec un dérivé d'acide dicarbonique ayant la structure suivante: 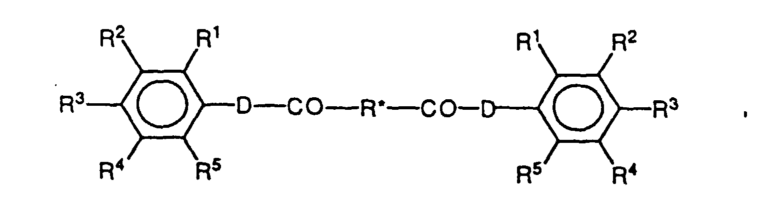 dans laquelle:
D = O, S ou NH;
R¹, R², R³, R⁴ et R⁵ sont - indépendamment l'un de l'autre - du H, F, CH₃ ou CF₃, au moins un des résidus R¹ à R⁵ étant du F et/ou du CF₃ et au plus deux des résidus R¹ à R⁵ étant du CH₃ et/ou du CF³;
R* a la signification suivante:
- (CR₂)ₘ avec R = H, F, CH₃ ou CF₃
et m = 1 à 10;
- 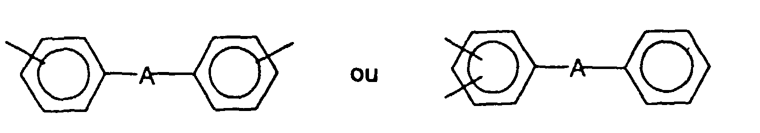
avec A = (CH₂)ₙ, (CF₂)ₚ, C(CH₃)₂, C(CF₃)₂, C(CH₃)(C₆H₅), C(CF₃)(C₆H₅), C(CF₃)(C₆F₅), C(C₆H₅)₂, CF₂-CF(CF₃), CH=CH, CF=CF, C≡C, O-C₆H₄-O, O, S, CO ou SO₂, dans lequel n = 0 à 10 et p = 1 à 10;
- 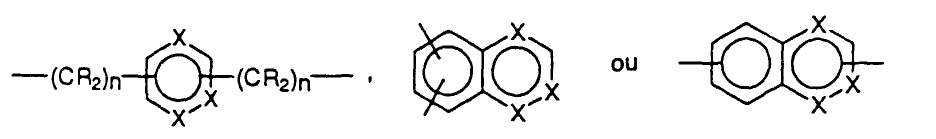 avec
X = CH ou N
R = H, F, CH₃ ou CF₃
et
n = 0 à 10;
- 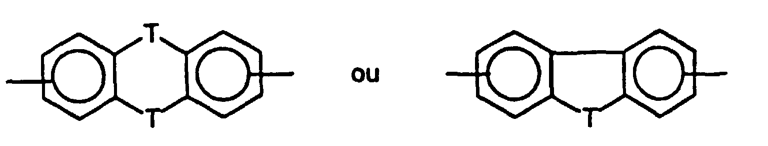 avec T = CH₂, CF₂, CO, O, S, NH ou N(CH₃);
- 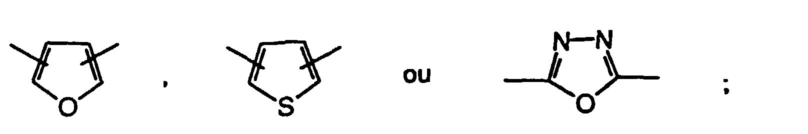
- 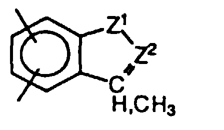 avec
Z¹ = CH₂ ou CH(CH₃) et Z² = CH ou C(CH₃)
Z¹ = CH₂ ou CH(CH₃) et Z² = N
Z¹ = NH ou N(CH₃) et Z² = CH ou C(CH₃)
Z¹ = NH ou N(CH₃) et Z² = N 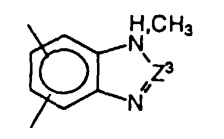
avec Z³ = CH C(CH₃) ou N 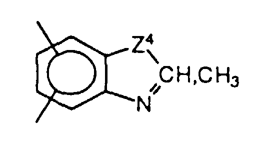 avec Z⁴ = O ou S;
tous les atomes d'hydrogène (H) pouvant être remplacés par du fluor (F) sur toutes les structures aromatiques partielles.

2. Procédé selon la revendication 1 **caractérisé par le fait** qu'on utilise un ester d'acide dicarbonique avec un perfluorphénole.

3. Procédé selon la revendication 1 ou 2 **caractérisé par le fait** que la transformation se fait en présence d'un catalyseur basique.

4. Procédé selon la revendication 3 **caractérisé par le fait** que le catalyseur est une amine tertiaire.

5. Procédé selon l'une des revendications 1 à 4 **caractérisé par le fait** que la transformation est effectuée à des températures de 20 à 150°C.

6. Procédé selon la revendication 5 **caractérisé par le fait** que la température est augmentée graduellement.
